(19) Europäisches Patentamt
European Patent Office
Office européen des brevets

(11) Veröffentlichungsnummer: **0 336 272 B1**

(12) **EUROPÄISCHE PATENTSCHRIFT**

(45) Veröffentlichungstag der Patentschrift: **28.07.93**

(51) Int. Cl.$^5$: **H03H 17/02**

(21) Anmeldenummer: **89105517.0**

(22) Anmeldetag: **29.03.89**

# (54) Impulskompressionsfilter.

(30) Priorität: **02.04.88 DE 3811282**

(43) Veröffentlichungstag der Anmeldung:
**11.10.89 Patentblatt 89/41**

(45) Bekanntmachung des Hinweises auf die Patenterteilung:
**28.07.93 Patentblatt 93/30**

(84) Benannte Vertragsstaaten:
**AT BE CH DE ES FR GB GR IT LI LU NL SE**

(56) Entgegenhaltungen:
**DE-A- 3 033 226**

**RADIO AND ELECTRONIC ENGINEER, Band 54, Nr. 6, Juni 1984, Seiten 244-250, IERE, London, GB; R. BICOCCHI et al.: "Radar sensitivity and resolution in presence of range sidelobe reducing networks designed using linear programming"**

**FREOUENZ, Band 40, Nr. 8, August 1986, Seiten 215-220; H.D. LÜKE: "Folgen mit perfekten periodischen Auto- und Kreuzkorrelationsfunktionen"**

**NTZ ARCHIV, Band 10, Nr. 5, Mai 1988, Seiten 111-117; H. ROHLING et al.: "Zum Mismatched-Filter-Entwurf für periodische binärphasencodierte Signale"**

(73) Patentinhaber: **Deutsche Aerospace Aktiengesellschaft**

**W-8000 München(DE)**

(72) Erfinder: **Borchert, Wolfgang, Dipl.-Phys.**
**Franz-Wiedemeier-Strasse 99**
**W-7900 Ulm(DE)**
Erfinder: **Rohling, Hermann, Dr.rer.nat.**
**Im Wiblinger Hart 33**
**W-7900 Ulm 10(DE)**

(74) Vertreter: **Schulze, Harald Rudolf, Dipl.-Ing.**
**Deutsche Aerospace AG Patentabteilung**
**Postfach 17 30**
**W-7900 Ulm (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 336 272 B1

## Beschreibung

Die Erfindung betrifft ein Impulskompressionsfilter der im Oberbegriff des Patentanspruchs 1 angegebenen Art.

Es ist bekannt, daß z.B. bei der Entfernungsmessung bei Radarsystemen oder zur Impulsantwortmessung eines Übertragungskanals anstelle kurzer leistungsstarker Impulse auch codierte Impulsfolgen mit wesentlich geringer Leistung der Einzelpulse ausgesandt werden können, wenn im Empfänger ein Kompressionsfilter vorhanden ist, das die empfangenen Impulsfolgen durch Faltung mit der Filterimpulsantwort komprimiert (Korrelationsempfang). Die Korrelationsfunktion weist i.a. ein deutliches Maximum (Hauptwert) und mehr oder weniger ausgeprägte Nebenzipfel (Nebenwerte) auf. In der Radartechnik z.B. können durch diese Nebenzipfel (in Entfernungsrichtung) schwache Ziele von starken Zielen maskiert und somit nicht entdeckt werden (Auflösungsproblem). Es besteht daher grundsätzlicher Bedarf am Einsatz von Pulsfolgen und zugeordneten Kompressionsfiltern, deren Korrelationsfunktion möglichst niedrige, im Idealfall überhaupt keine Nebenzipfel aufweist.

Besonders bekannt bei der Impulskompression sind die sogenannten "Matched Filter", welche die Autokorrelationsfunktion der Impulsfolge bilden. Die Minimierung der Nebenzipfel ist in diesem Fall eine reine Aufgabe der Codesynthese. Für aperiodische Folgen sind Untersuchungen zur Codesynthese beispielsweise in /1/ beschrieben. Andererseits werden Signalverarbeitungstechniken untersucht, mit denen bei der Impulskompression sogenannte Mismatched Filter eingesetzt werden /2/, die als Ausgangssignal die Kreuzkorrelationsfunktion (KKF) der Impulsfolge liefern. Das Entwurfsziel besteht darin, in der Kreuzkorrelationsfunktion einen größeren Haupt-Nebenzipfel-Abstand zu erreichen als in der Autokorrelationsfunktion der benutzten Impulsfolge.

Interessanter als aperiodisch ausgesandte codierte Impulsfolgen sind für die Anwendung, beispielsweise in den eingangs angeführten Problemstellungen, die periodisch wiederholten Signalfolgen. Die Ausgangssignale der jeweils zugehörigen Kompressionsfilter werden entsprechend als periodische Auto- bzw. Kreuzkorrelationsfunktionen (PAKF bzw. PKKF) bezeichnet. In diesem Zusammenhang sind beispielsweise die sogenannten Maximum Length Codes (MLC) bekannt, deren PAKF ein konstantes Nebenzipfelniveau von -1 hat.

Aus der DE-A-30 33 226 sind Mismatched Filter für binärcodierte Impulsfolgen bekannt, die gegenüber dem Matched Filter anstatt der Werte -1 die Filterkoeffizientenwerte Null besitzen. Dadurch werden im Idealfall alle Kompressionsnebenwerte zu Null. Dieser Filterentwurf ist, wie sich zeigen läßt, beschränkt auf Impulsfolgen der Länge $N = 4 \cdot G - 1$ (G ganzzahlig), bei deren PAKF alle Nebenwerte gleich -1 sind. Der Integrationsgewinn ist dabei nur rund 50%, bezogen auf die Matched-Filter-Kompression.

In der Literatur /3,4/ sind auch in größerer Anzahl Codes für periodische Folgen angegeben, deren PAKF nebenzipfelfrei ist. Diese Folgen lassen sich aber in der Regel nicht als Binärcodes darstellen. Aus technischen Gründen sind aber gerade die Binärcodes von besonderer Bedeutung, da durch binäre Phasencodierung Sendesignale mit konstanter Signaleinhüllender erzeugt werden können.

Nach Lüke /3/ gibt es nur eine binäre Folge, deren PAKF perfekt ist, d.h. deren Nebenzipfel vollständig verschwinden. Diese Folge hat die binäre Codierung 111-1. Für alle anderen Binärcodes ist die PAKF des Signals nicht perfekt.

Der Erfindung liegt die Aufgabe zugrunde, ein Filter zur Kompression periodisch wiederholter binärwertiger Impulsfolgen (zyklische Codes), außer den bekannten Impulsfolgen, anzugeben, die eine periodische Kreuzkorrelationsfunktion mit sehr niedrigen oder verschwindenden Nebenzipfeln aufweist.

Die Erfindung ist im Patentanspruch 1 beschrieben. Die Unteransprüche enthalten besonders vorteilhafte Anwendungsformen der Erfindung.

Die Filterkoeffizienten sind bei dem erfindungsgemäßen Filter für eine gegebene Impulsfolge in eindeutiger Weise durch die Binärwerte der Codestellen der Impulsfolge festgelegt. Die erfindungsgemäße Einstellung der Filterkoeffizienten ist im Prinzip für Impulsfolgen beliebiger Länge (Anzahl N der Codestellen) gültig, außer für Impulsfolgen, deren über die diskrete Fouriertransformation (DFT) zugeordnetes Spektrum mindestens eine Nullstelle aufweist, d.h. bei dem einer der Spektralkoeffizienten dem Betrag nach gleich Null ist. Es läßt sich zeigen, daß für jede beliebige Codelänge N mindestens eine Impulsfolge existiert, für die ein Kompressionsfilter nach der Erfindung aufgebaut werden kann, das eine perfekte periodische Kreuzkorrelationsfunktion liefert.

Ausgehend von einer Impulsfolge der Länge N mit den Codestellen $c_i$ des periodisch wiederholten Codeworts $\underline{c}$ ergibt sich durch die periodische Wiederholung ein Sendesignal mit den im Takt des Impulsabstand aufeinanderfolgenden Signalwerten

$$s_i = c_{i \bmod (N)}, i = 0,1,2.....$$

Wird dieses Signal über das Kompressionsfilter mit den erfindungsgemäß eingestellten Filterkoeffizienten geführt so ergibt sich als Filterausgangssignal die perfekte periodische Kreuzkorrelationsfunktion

$$PKKF_{sw}(m) = \sum_{k=o}^{N-1} s_{k+m} \cdot w_k = \begin{cases} 1 \text{ für } m = 0 \text{ modulo } N \\ 0 \text{ sonst} \end{cases}$$

(Abweichend von dieser Definition der perfekten periodischen Kreuzkorrelationsfunktion wird in /3/ der Begriff der perfekten PKKF für eine Funktion gebraucht, die an jeder Stelle den Wert Null annimmt.)

Wenngleich im folgenden aus Gründen der Anschaulichkeit immer die Beträge (Absolutwerte) des Zeitsignals s (bzw. der Codewerte $c_i$), der Filterkoeffizienten $w_k$ und der Spektrumswerte der DFT-Spektren beschrieben und skizziert sind, werden vorzugsweise die Empfangssignale komplex demoduliert und entsprechend in einem einen I- und einen Q-Zweig aufweisenden Kompressionsfilter verarbeitet. Die Filterkoeffizienten $w_k$ sind reell.

Nachfolgend sind anhand von Beispielen und unter Bezugnahme auf die Abbildungen Grundlage und Wirkung der erfindungsgemäßen Filtereinstellung noch eingehend veranschaulicht.

Dabei zeigt

| | |
|---|---|
| FIG. 1A | eine Impulsfolge (Codewort), auf die die Erfindung anwendbar ist und |
| FIG. 1B | das zugehörige DFT-Betragsspektrum |
| FIG. 1C | den auf die Impulsfolge der FIG. 1A abgestimmten Filterkoeffizientensatz |
| FIG. 1D | das DFT-Spektrum des Filterkoeffizientensatzes nach FIG. 1 |
| FIG. 1E | die periodische Kreuzkorrelationsfunktion der Impulsfolge nach FIG. 1A und der Filterfunktion nach FIG. 1C |
| FIG. 1F | das DFT-Spektrum der PKKF nach FIG. 1E |
| FIG. 2A | eine weitere Impulsfolge gleicher Länge wie in FIG. 1A |
| FIG. 2B | das zugehörige DFT-Spektrum |
| FIG. 3A | ein Signal $s_K$ mit einem periodisch wiederholten Codewort c |
| FIG. 3B | den zum Codewort c nach FIG. 3A gehörenden Filterkoeffizientensatz $w_k$ |
| FIG. 3C | die sich aus $s_K$ (FIG. 3A) und $w_k$ (FIG. 3B) ergebende periodische Kreuzkorrelationsfunktion $PKKF_{sw}$ |

Die Betrachtung der über die DFT zugeordneten Spektren erweist sich sowohl zur Erläuterung der Erfindung als auch zur Berechnung der Koeffizientenwerte $w_k$ zu einem gegebenen Codewort $\underline{c}$ als besonders vorteilhaft.

Bei gegebener Impulsfolge $\underline{c}$ der Länge N mit den binären Codestellen $c_i$ wird vorteilhafterweise in einem ersten Schritt mittels der diskreten Fouriertransformation das zugehörige DFT-Spektrum mit den Spektralkoeffizienten

$$Z_n = \frac{1}{N} \sum_{l=0}^{N-1} c_l \exp(-j \cdot 2\pi \cdot \frac{n}{N} l)$$

und durch Multiplikation mit dem konjugiert komplexen Wert $Z_n^*$ auch die Betragsquadrate der Spektralkoeffizienten

$$|Z_n|^2 = \frac{1}{N^2} \sum_{l=0}^{N-1} \sum_{m=0}^{N-1} c_l \cdot c_m \exp(-j \cdot 2\pi \cdot \frac{n}{N} (l-m))$$

ermittelt. Wenn für alle n gilt

$|Z_n|^2 \neq 0$.

kann für die vorgegebene Impulsfolge ein Kompressionsfilter erfindungsgemäß dimensioniert werden. Zur quantitativen Ermittlung der Koeffizientenwerte $w_k$ des Kompressionfilters werden unter Rückgriff auf die bereits ermittelten Spektralwerte $Z_n$ der Impulsfolge bzw. deren konjugierte komplexe Werte $Z_n^*$ und Beträge $|Z_n|^2$ zuerst die Werte

$$W_n = F \cdot \frac{Z_n^*}{|Z_n|^2} \qquad (n = 0, 1, 2 \ldots N-1),$$

die zusammen wiederum als ein Spektrum betrachtet werden können, gebildet und aus diesen N Werten werden mittels einer inversen diskreten Fouriertransformation unmittelbar die N Filterkoeffizienten

$$w_k = F \cdot \sum_{n=0}^{N-1} W_n \cdot \exp(j \cdot 2\pi \cdot \frac{n}{N} \cdot k)$$

$$(k = 0, 1, 2 \ldots N-1)$$

gebildet, wobei der für alle k gleiche konstante Faktor F im Grunde willkürlich gewählt werden und damit z.B. zur Normierung auf ganzzahlige Koeffizientenwerte oder auf einen maximalen Koeffizientenwert dienen kann. Die einzelnen Schritte des aufgezeigten Berechnungsweges sind eindeutig, so daß sich daraus bei gegebener Impulsfolgencodierung die Werte für die Filterkoeffizienten eindeutig ergeben. Äquivalente Wege zur Berechnung der Filterkoeffizienten, z.B. über die Bildung von Determinanten von Matrizen aus der Impulsfolge und der PKKF, sind möglich und führen zu denselben Koeffizientensätzen, die durch die erfindungsgemäße Lehre quantitativ festgelegt sind.

Das in FIG. 1A dargestellte Codewort der Länge N = 12 besitzt die Folge

-1 +1 -1 +1 +1 +1 +1 +1 -1 -1 +1 +1

der Binärwerte +1, -1. Das DFT-Spektrum dieser Folge zeigt die FIG. 1B. Das gewünschte Ausgangssignal des mit dem periodisch wiederholten Codewort $\underline{c}$ beaufschlagten Kompressionsfilters, nämlich die perfekte periodische Kreuzkorrelationsfunktion, kann als periodisch wiederholter Diracstoß betrachtet werden. Dessen DFT-Spektrum weist bekanntermaßen lauter gleiche Werte auf. Bei Betrachtung der Impulskompression im Frequenzbereich ist also dann eine perfekte PKKF (im Zeitbereich) zu erreichen, wenn das DFT-Spektrum des Filterausgangssignals lauter gleiche Werte aufweist. Der Korrelation der periodischen Folge mit der Filterfunktion im Zeitbereich entspricht einer Multiplikation der zugehörigen Spektren.

Für das in FIG. 1A dargestellte Codewort ergibt sich bei erfindungsgemäßer Einstellung der Filterkoeffizienten

| $w_0$ | $w_1$ | $w_2$ | $w_3$ | $w_4$ | $w_5$ | $w_6$ | $w_7$ | $w_8$ | $w_9$ | $w_{10}$ | $w_{11}$ |
|---|---|---|---|---|---|---|---|---|---|---|---|
| -2 | +1 | +1 | -2 | -1 | +1 | +2 | -1 | +1 | +2 | -1 | +1, |

der in FIG. 1C abgebildet ist.

Da Impulskompression mit einem Filter äquivalent ist der Korrelation mit einem Korrelator, lassen sich die Gewichte des Korrelators aus den Filterkoeffizienten herleiten, wobei sich im Beispielsfall die Korrelatorgewichte $w_k'$ ergeben zu

| $w'_0$ | $w'_1$ | $w'_2$ | $w'_3$ | $w'_4$ | $w'_5$ | $w'_6$ | $w'_7$ | $w'_8$ | $w'_9$ | $w'_{10}$ | $w'_{11}$ |
|---|---|---|---|---|---|---|---|---|---|---|---|
| -2 | +1 | -1 | +2 | +1 | +1 | +2 | +1 | -1 | -2 | +1 | +1 |

Das zu diesem Filterkoeffizientensatz gehörige DFT-Spektrum zeigt die FIG. 1D. Durch Multiplikation des DFT-Spektrums $Z_c$ (FIG. 1B) des Codeworts c mit dem DFT-Spektrum W des Filterkoeffizientensatzes ergibt sich für das Produktspektrum $Z_p$ ein in allen Frequenzintervallen konstanter Pegel und entsprechend eine perfekte PKKF für das Korrelationsprodukt im Zeitbereich.

Bei Verwendung der als Beispiel beschriebenen periodischen Impulsfolge und des erfindungsgemäß dimensionierten Mismatched Filters ergibt sich ein Integrationsgewinn von $I_{MMF} \approx 10,7$ gegenüber einem Integrationsgewinn von $I_{MF} = 12$ für die Verwendung eines Matched Filters und damit ein Verlust im Signal-Rausch-Verhältnis von nur ca. 0,5 dB gegenüber der Matched-Filter Prozedur. Dafür ergibt sich aber bei einfach aufgebautem Mismatched-Filterkoeffizientensatz eine völlig nebenzipfelfreie PKKF.

Zur Erläuterung der einschränkenden Bedingung, daß die Erfindung nur für solche Impulsfolgen gilt, deren DFT-Spektrum keine Nullstelle aufweist, ist in FIG. 2A eine weitere Impulsfolge (Codewort) der Länge N = 12 und in FIG. 2B deren DFT-Spektrum angegeben. Dieses DFT-Spektrum weist drei Nullstellen auf. Es ist offensichtlich, daß in der Betrachtung des Frequenzbereichs kein DFT-Spektrum einer Filterfunktion existiert, das durch Multiplikation mit dem DFT-Spektrum der Impulsfolge zu einem Produktspektrum mit in allen Frequenzintervallen gleichem Pegel führt, da die Nullstellen multiplikativ nicht beseitigt werden können.

Die Überprüfung einer speziellen Impulsfolge auf ihre Eignung für ein erfindungsgemäß zu dimensionierendes Kompressionsfilter kann generell durch Bildung ihres DFT-Betragsspektrums erfolgen. Für Sonderfälle können auch bereits aus der Struktur einer Impulsfolge im Zeitbereich Schlußfolgerungen auf deren prinzipielle Eignung gezogen werden. So ist z.B. eine binäre Impulsfolge mit geradzahliger Codelänge N = 2M grundsätzlich nicht geeignet,

a) falls die Anzahl der Koeffizienten für beide Werte ± 1 gleich groß, also gleich M ist, oder

b) falls alle Koeffizienten gleicher binärer Wertigkeit zusammenhängend angeordnet sind und deren Anzahl gleichfalls geradzahlig ist.

Andererseits ist eine perfekte PKKF mit einem erfindungsgemäß einzustellenden Kompressionsfilter grundsätzlich erreichbar,

a) falls die Codelänge N eine Primzahl ist (und die Codestellen nicht trivialerweise alle identisch sind), oder

b) falls bei einem binären Codewort alle Codewerte außer einem einzigen gleich sind.

Aus der zuletzt aufgestellten Regel ist ableitbar, daß zu jeder beliebigen Codelänge N mindestens eine Impulsfolge existiert, die mittels eines erfindungsgemäß einzustellenden Kompressionsfilters perfekt komprimierbar ist. In der Regel gibt es zu einer bestimmten Codelänge eine Mehrzahl geeigneter unterschiedlicher Codeworte. Diese unterscheiden sich nicht nur in ihren zugeordneten Mismatched-Filtern, sondern auch in dem bei der Impulskompression erzielbaren Integrationsgewinn. Ja nach Anforderung des Einzelfalls kann die geeignetste Impulsfolge nach den jeweils maßgeblichen Kriterien, wie z.B. möglichst hoher Integrationsgewinn oder geringe Streuung der Koeffizientenwerte usw., ausgewählt werden.

Ein weiteres Beispiel eines periodischen Signals $s_K$ mit einem periodisch wiederholten 13-Bit-barker-Codewort zeigt FIG. 3A. Den zugehörigen Korrelator zur Erzielung einer perfekten periodischen Kreuzkorrelationsfunktion PKKF (FIG. 3C) sind in FIG. 3B eingetragen. Mit dieser Kombination von Impulsfolge und Mismatched-Filter wird ein Integrationsgewinn von $I_{MMF} = 12,5$ erzielt. Aus umfangreicheren systematischen Untersuchungen einer größeren Zahl von Codeworten unterschiedlicher Codelänge kann die Erkenntnis extrahiert werden, daß für nahezu jede Codelänge ein Codewort existiert, dessen nach der Erfindung dimensioniertes Mismatched-Filter einen hohen Integrationsgewinn aufweist, der gegenüber dem Integrationsgewinn eines Matched-Filters nur ca. 10 % oder weniger verringert ist.

Abweichungen von der theoretisch perfekten PKKF können sich in der Realität bei analoger Korrelation durch Fertigungstoleranzen, bei digitaler Korrelation durch Quantisierungsfehler bei die digitale Auflösung überschreitender Streuung der Koeffizientenwerte ergeben.

Das beschriebene Impulskompressionsfilter ist besonders vorteilhaft einsetzbar zur Impulskompression eines Pulsradars mit pulscodierten Sendesignalen und zur Kompression von über einen Funkkanal insbesondere im Kurzwellenbereich übertragenen Testimpulsfolgen in einem Funkempfänger.

Literatur

/1/ Cook, Bernfeld, Radar Signals, Academic Press, New York, 1967
/2/ Seydler, P., Nebenzipfelreduktion bei Impulskompression binär phasencodierter Signale, Dissertation RWTH Aachen, 1974
/3/ Lüke, Folgen mit perfekten periodischen Auto- und Kreuzkorrelationsfunktionen, FREQUENZ, 1986, Heft 8, S. 215 - 220
/4/ Frank, Zadoff, Phase Shift with good Periodic Correlation Properties, IRE Trans., IT-8, 1962, pp. 381 - 382

## Patentansprüche

1. Impulskompressionsfilfter mit N Filterkoeffizienten $w_k$ (k = 0, 1, 2 ... N-1), wobei N>4 ist, zur Impulskompression von Signalen mit periodisch wiederholten binärcodierten Impulsfolgen mit N Codestellen $c_i$ = ±1 (i = 0, 1, 2 ... N- 1), mit Ausnahme von Impulsfolgen der Länge N = 4 • G - 1 (G = 1, 2, ...), in deren periodischer Autokorrelationsfunktion alle Nebenwerte gleich -1 sind, dadurch gekennzeichnet, daß für Impulsfolgen, bei deren über die diskrete Fouriertransformation (DFT) zugeordnetem Spektrum für alle Spektralkoeffizienten $Z_n$ (n = 0, 1, 2 ... N-1) das Betragsquadrat

$$\left|Z_n\right|^2 = \frac{1}{N^2} \sum_{l=0}^{N-1} \sum_{m=0}^{N-1} c_l \cdot c_m \cdot \exp\left(-j \cdot 2\pi \cdot \frac{n}{N}(l-m)\right)$$

ungleich Null ist, die Filterkoeffizienten $w_k$ reell sind und die Werte

$$w_k = F \cdot \sum_{n=0}^{N-1} \left\{ \frac{1}{\left|Z_n\right|^2} \cdot \sum_{p=0}^{N-1} c_p \cdot \exp\left(j \cdot 2\pi \cdot \frac{n}{N} \cdot p\right) \right\} \cdot \exp\left(j \cdot 2\pi \cdot \frac{n}{N} \cdot k\right)$$

aufweisen, wobei F ein für alle k konstanter Faktor ist.

2. Impulskompressionsfilter nach Anspruch 1, dadurch gekennzeichnet, daß die Filtereingangssignale in quadraturdemodulierter Form vorliegen und das Filter einen I- und einen Q-Zweig aufweist.

3. Impulskompressionsfilter nach Anspruch 1 oder 2, dadurch gekennzeichnet, daß das Filter Bestandteil einer Pulsradaranlage mit Pulscodierung ist.

4. Impulskompressionsfilter nach Anspruch 1 oder 2, dadurch gekennzeichnet, daß das Filter in einem Funkempfänger zur Kompression von über einen Funkkanal übertragenen Testimpulsfolgen eingesetzt ist.

## Claims

1. Pulse compression filter with N filter co-efficients $w_k$ (k=0, 1, 2 to N-1), wherein N is greater than 4, for the pulse compression of signals with periodically repeated pulse sequences in binary code with N code places $c_i$ = ±1(i = 0, 1, 2 to N-1), with the exception of pulse sequences of the length N=4.G-1-(G=1, 2 ...), in the periodic autocorrelation function of which all side values are equal to -1, characterised thereby, that for pulse sequences, for the spectrum associated by way of the discrete Fourier transformation of which the squared magnitude

$$\left|Z_n\right|^2 = \frac{1}{N^2} \sum_{l=0}^{N-1} \sum_{m=0}^{N-1} c_l \cdot c_m \cdot \exp\left(-j \cdot 2\pi \cdot \frac{n}{N}(l-m)\right)$$

is unequal to zero for all spectral co-efficients $Z_n$(n = 0, 1, 2 to N-1), the filter co-efficients $w_k$ are real and display the values

$$w_k = F \cdot \sum_{n=0}^{N-1} \left\{ \frac{1}{\left|Z_n\right|^2} \cdot \sum_{p=0}^{N-1} c_p \cdot \exp(j \cdot 2\pi \cdot \frac{n}{N} \cdot p) \right\} \cdot \exp(j \cdot 2\pi \cdot \frac{n}{N} \cdot k)$$

wherein F is a factor that is constant for every k.

**2.** Pulse compression filter according to claim 1, characterised thereby, that the filter input signals are present in quadrature-demodulated form and the filter comprises an I-branch and a Q-branch.

**3.** Pulse compression filter according to claim 1 or 2, characterised thereby, that the filter is component of a pulse radar installation with pulse coding.

**4.** Pulse compression filter according to claim 1 or 2, characterised thereby, that the filter is used in a radio receiver for the compression of test pulse sequences transmitted over a radio channel.

**Revendications**

**1.** Filtre de compression d'impulsions présentant M coefficients de filtre $w_k$ (k = 0, 1, 2 ... N-1), N étant supérieur à 4, pour la compression d'impulsions de signaux comportant des trains d'impulsions codés binaires répétés périodiquement, possédant N positions de code $c_i$ = ± 1 (i = 0, 1, 2 ... N-1), à l'exception de trains d'impulsions de la longueur N = 4 • G - 1 (G = 1, 2, ...), dans la fonction d'autocorrélation périodique desquels toutes les valeurs secondaires sont égales à -1, caractérisé en ce que pour des trains d'impulsions dont le spectre coordonné par la transformation de Fourier discrète (DFT) présente, pour tous les coefficients spectraux $Z_n$ (n = 0, 1, 2 ...N-1), une valeur absolue dont le carré

$$\left|Z_n\right|^2 = \frac{1}{N^2} \sum_{l=0}^{N-1} \sum_{m=0}^{N-1} c_l \cdot c_m \cdot \exp\left(-j \cdot 2\pi \cdot \frac{n}{N}(l-m)\right)$$

diffère de zéro, et les coefficients de filtre $w_k$ sontréels et présentent les valeurs

$$w_k = F \cdot \sum_{n=0}^{N-1} \left\{ \frac{1}{\left|Z_n\right|^2} \cdot \sum_{p=0}^{N-1} c_p \cdot \exp(j \cdot 2\pi \cdot \frac{n}{N} \cdot p) \right\} \cdot \exp(j \cdot 2\pi \cdot \frac{n}{N} \cdot k)$$

où F est un facteur constant pour tous les k.

**2.** Filtre de compression d'impulsions selon la revendication 1, caractérisé en ce que les signaux d'entrée du filtre se présentent sous forme démodulée en quadrature et le filtre possède une branche I et une branche Q.

3. Filtre de compression d'impulsions selon la revendication 1 ou 2, caractérisé en ce qu'il fait partie d'une installation de radar à impulsions avec codage par impulsions.

4. Filtre de compression d'impulsions selon la revendication 1 ou 2, caractérisé en ce qu'il est utilisé dans un récepteur radioélectrique pour la compression de trains d'impulsions de test transmis par un canal radioélectrique.

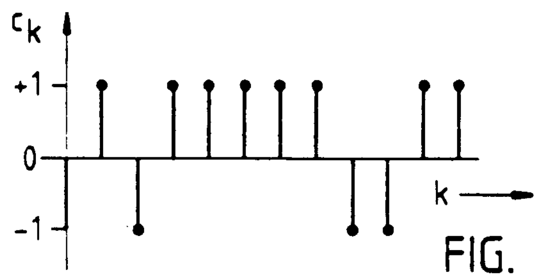


FIG. 1A

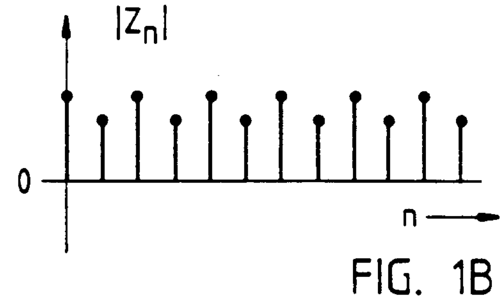


FIG. 1B

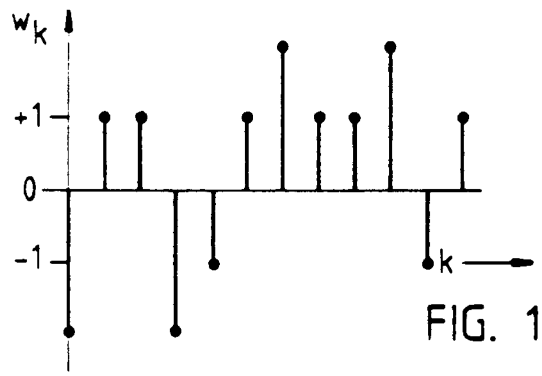


FIG. 1C

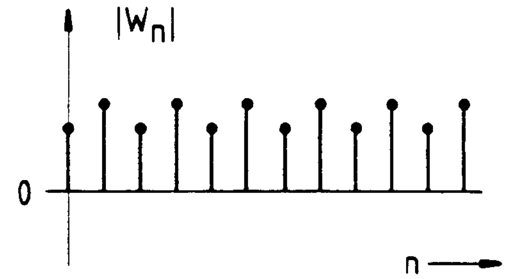


FIG. 1D

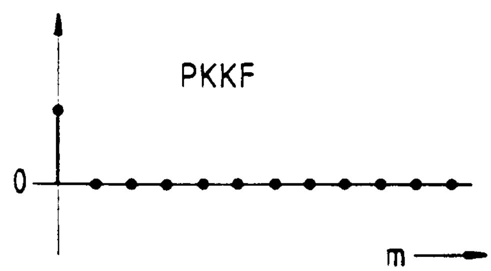


FIG. 1E

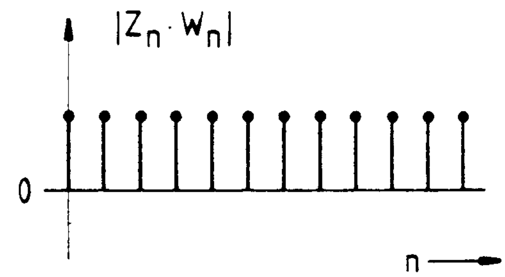


FIG. 1F

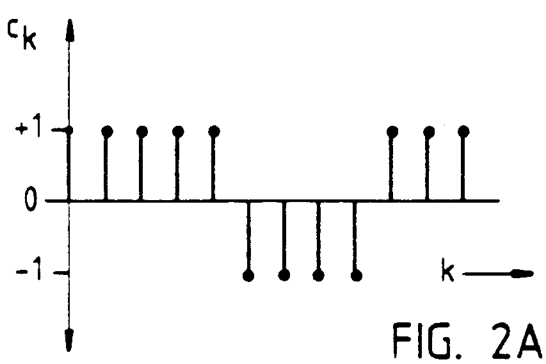


FIG. 2A

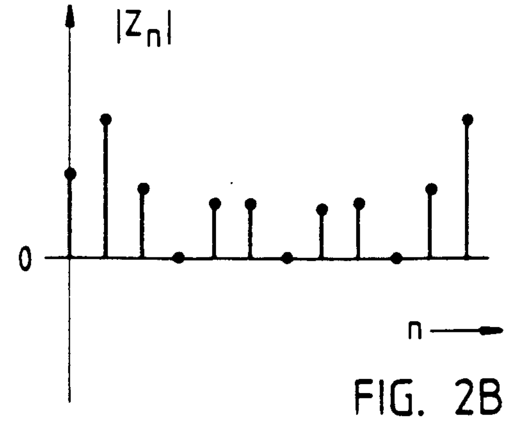


FIG. 2B

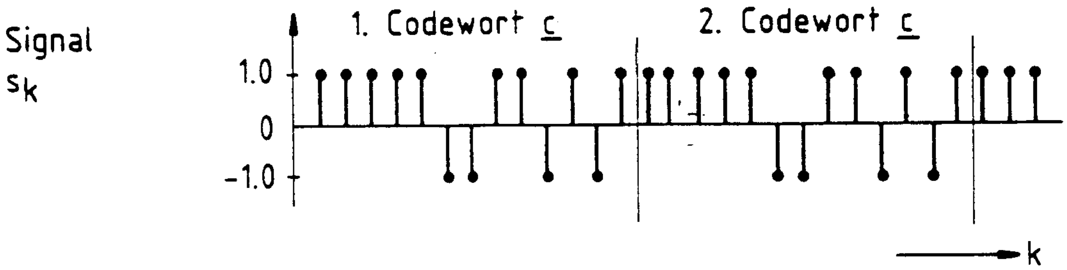


FIG. 3A

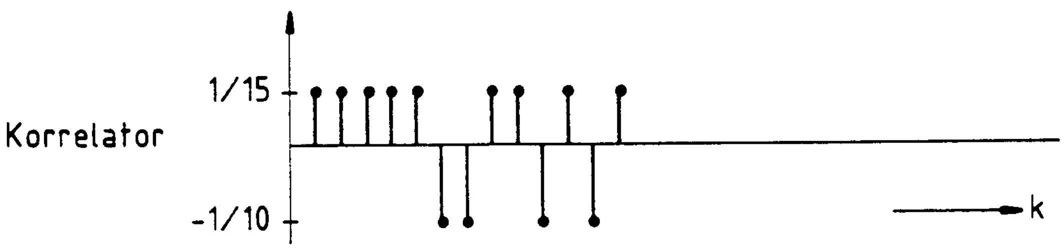


FIG. 3B

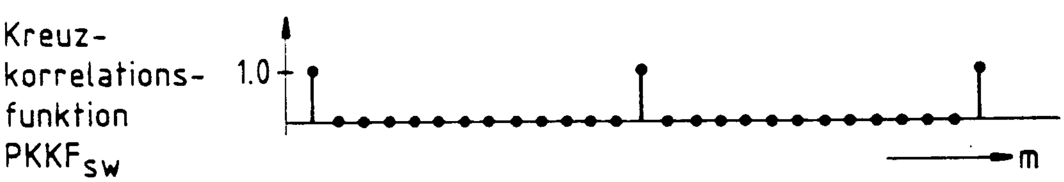


FIG. 3C